# EUROPÄISCHE PATENTSCHRIFT

(11) **EP 4 274 041 B1**
(45) Veröffentlichungstag und Bekanntmachung des Hinweises auf die Patenterteilung: **09.10.2024**
(21) Anmeldenummer: 23170668.0
(22) Anmeldetag: 28.04.2023
(51) Int. Cl.: H02B 1/052, H01R 9/26, H01H 71/10

(54) **MODULARES ISOLIERSTOFFGEHÄUSE UND MEHRPOLIGES MODULARES REIHENEINBAUGERÄT**
MODULAR INSULATING MATERIAL HOUSING AND MULTIPOLE MODULAR SERIES INSTALLATION DEVICE
BOÎTIER ISOLANT MODULAIRE ET APPAREIL MODULAIRE MULTIPOLAIRE À MONTAGE EN SÉRIE

(30) Priorität: 02.05.2022 DE 102022204329
(43) Veröffentlichungstag der Anmeldung: 08.11.2023
(73) Patentinhaber: Siemens Aktiengesellschaft, 80333 München (DE)
(72) Erfinder: Ness, Franz, 84092 Bayerbach (DE); Nörl, Gerald, 93133 Burglengenfeld (DE)
(74) Vertreter: Siemens Patent Attorneys

(56) Entgegenhaltungen:
- EP-A1- 2 234 139
- EP-A1- 2 704 274
- DE-A1- 102011 087 209
- US-A1- 2014 246 299

## Beschreibung

Die Erfindung betrifft ein modulares Isolierstoffgehäuse für ein mehrpoliges modulares Reiheneinbaugerät, aufweisend eine Frontseite, eine der Frontseite gegenüberliegende Befestigungsseite sowie die Front- und die Befestigungsseite verbindende erste und zweite Schmal- und Breitseiten. Weiterhin betrifft die Erfindung ein mehrpoliges modulares Reiheneinbaugerät mit einem derartigen modularen Isolierstoffgehäuse.

Derartige Isolierstoffgehäuse für mehrpolige Reiheneinbaugeräte sind beispielsweise aus den Dokumenten EP 2 234 139 A1 und US 2014/246299 A1 bekannt.

Elektromechanische Schutzschaltgeräte - beispielsweise Leistungsschalter, Leitungsschutzschalter, Fehlerstromschutzschalter sowie Lichtbogen- bzw. Brandschutzschalter - dienen der Überwachung sowie der Absicherung eines elektrischen Stromkreises und werden insbesondere als Schalt- und Sicherheitselemente in elektrischen Energieversorgungs- und Verteilnetzen eingesetzt. Zur Überwachung und Absicherung des elektrischen Stromkreises wird das Schutzschaltgerät über zwei oder mehrere Anschlussklemmen mit einer elektrischen Leitung des zu überwachenden Stromkreises elektrisch leitend verbunden, um bei Bedarf den elektrischen Strom in der jeweiligen überwachten Leitung zu unterbrechen. Das Schutzschaltgerät weist hierzu zumindest einen Schaltkontakt auf, der bei Auftreten eines vordefinierten Zustandes - beispielsweise bei Erfassen eines Kurzschlusses oder eines Fehlerstromes - geöffnet werden kann, um den überwachten Stromkreis vom elektrischen Leitungsnetz zu trennen. Derartige Schutzschaltgeräte sind auf dem Gebiet der Niederspannungstechnik auch als Reiheneinbaugeräte bekannt.

Leistungsschalter sind dabei speziell für hohe Ströme ausgelegt. Ein Leitungsschutzschalter (sogenannter LS-Schalter), welcher auch als "Miniature Circuit Breaker" (MCB) bezeichnet wird, stellt in der Elektroinstallation eine sogenannte Überstromschutzeinrichtung dar und wird insbesondere im Bereich der Niederspannungsnetze eingesetzt. Leistungsschalter und Leitungsschutzschalter garantieren ein sicheres Abschalten bei Kurzschluss und schützen Verbraucher und Anlagen vor Überlast, beispielsweise vor Beschädigung der elektrischen Leitungen durch zu starke Erwärmung in Folge eines zu hohen elektrischen Stromes. Sie sind dazu ausgebildet, einen zu überwachenden Stromkreis im Falle eines Kurzschlusses oder bei Auftreten einer Überlast selbsttätig abzuschalten und damit vom übrigen Leitungsnetz zu trennen. Leistungsschalter und Leitungsschutzschalter werden daher insbesondere als Schalt- und Sicherheitselemente zur Überwachung und Absicherung eines elektrischen Stromkreises in elektrischen Energieversorgungsnetzen eingesetzt. Leitungsschutzschalter sind aus den Druckschriften DE 10 2015 217 704 A1, EP 2 980 822 A1, DE 10 2015 213 375 A1, DE 10 2013 211 539 A1 oder auch EP 2 685 482 B1 prinzipiell vorbekannt.

Zur Unterbrechung einer einzigen Phasenleitung wird in der Regel ein einpoliger Leitungsschutzschalter verwendet, welche üblicher Weise eine Breite von einer Teilungseinheit (entspricht ca. 18mm) aufweist. Für dreiphasige Anschlüsse werden (alternativ zu drei einpoligen Schaltgeräten) dreipolige Leitungsschutzschalter eingesetzt, welche dementsprechend eine Breite von drei Teilungseinheiten (entspricht ca. 54mm) aufweisen. Jedem der drei Phasenleiter ist dabei ein Pol, d.h. eine Schaltstelle zugeordnet. Soll zusätzlich zu den drei Phasenleitern auch noch der Neutralleiter unterbrochen werden, spricht man von vierpoligen Geräten, welche vier Schaltstellen aufweisen: drei für die drei Phasenleiter sowie einen für den gemeinsamen Neutralleiter.

Daneben existieren kompakte Leitungsschutzschalter, welche bei einer Gehäusebreite von nur einer Teilungseinheit zwei Schaltkontakte für je eine Anschlussleitung, d.h. entweder für zwei Phasenleitungen (Kompaktleitungsschutzschalter vom Typ 1+1) oder für eine Phasenleitung und den Neutralleiter (Kompaktleitungsschutzschalter vom Typ 1+N), bereitstellen. Derartige Kompakt-Schutzschaltgeräte in Schmalbauweise sind beispielsweise aus den Druckschriften DE 10 2004 034 859 A1, EP 1 191 562 B1 oder EP 1 473 750 A1 prinzipiell vorbekannt.

Ein Fehlerstromschutzschalter ist eine Schutzeinrichtung zur Gewährleistung eines Schutzes gegen einen gefährlichen Fehlerstrom in einer elektrischen Anlage. Ein derartiger Fehlerstrom - welcher auch als Differenzstrom bezeichnet wird - tritt auf, wenn ein spannungsführendes Leitungsteil einen elektrischen Kontakt gegen Erde aufweist. Dies ist beispielsweise dann der Fall, wenn eine Person ein spannungsführendes Teil einer elektrischen Anlage berührt: in diesem Fall fließt der Strom als Fehlerstrom durch den Körper der betreffenden Person gegen die Erdung ab. Zum Schutz gegen derartige Körperströme muss der Fehlerstromschutzschalter bei Auftreten eines derartigen Fehlerstroms die elektrische Anlage schnell und sicher allpolig vom Leitungsnetz trennen. Im Allgemeinen Sprachgebrauch werden anstelle des Begriffs "Fehlerstromschutzschalter" auch die Begriffe FI-Schutzschalter (kurz: FI-Schalter), Differenzstromschutzschalter (kurz: DI-Schalter) oder RCD (für "Residual Current Protective Device") gleichwertig verwendet.

Zur Erfassung eines derartigen Fehler- bzw. Differenzstromes wird die Größe des Stromes in einer zu einem elektrischen Verbraucher hinführenden Leitung, beispielsweise einer Phasenleitung, mit der Größe des Stromes in einer vom elektrischen Verbraucher zurückführenden Leitung, beispielsweise eines Neutralleiters, mit Hilfe eines sogenannten Summenstromwandlers verglichen. Dieser weist einen ringförmigen Magnetkern auf, durch den die Primärleiter (hin- und rückführende elektrische Leitungen) hindurchgeführt sind. Der Magnetkern selbst ist mit einem Sekundärleiter bzw. einer Sekundärwicklung umwickelt. Im fehlerstromfreien Zustand ist die Summe der zu dem Verbraucher hinfließenden elektrischen Ströme gleich der Summe der vom Verbraucher zurückfließenden elektrischen Ströme. Werden die Ströme vektoriell, d.h. richtungsbezogen bzw. vorzeichenbehaftet, addiert, so folgt hieraus, dass die vorzeichenbehaftete Summe der elektrischen Ströme in den Hin- und Rückleitungen im fehlerstromfreien Zustand gleich Null ist: im Sekundärleiter wird kein Induktionsstrom induziert. Im Unterschied dazu ist im Falle eines Fehler- bzw. Differenzstromes, der gegen Erde abfließt, die im Summenstromwandler erfasste Summe der hin- beziehungsweise zurückfließenden elektrischen Ströme ungleich Null. Die dabei auftretende Stromdifferenz führt dazu, dass an der Sekundärwicklung eine der Stromdifferenz proportionale Spannung induziert wird, wodurch ein Sekundärstrom in der Sekundärwicklung fließt. Dieser Sekundärstrom dient als Fehlerstromsignal und führt nach Überschreiten eines vorbestimmten Wertes zum Auslösen des Schutzschaltgerätes und infolgedessen - durch Öffnen des zumindest einen Schaltkontaktes des Schutzschaltgerätes - zur Abschaltung des entsprechend abgesicherten Stromkreises.

Bei Fehlerstromschutzschaltern wird ferner zwischen netzspannungsabhängigen und netzspannungsunabhängigen Gerätetypen unterschieden: während netzspannungsabhängige Fehlerstromschutzschalter eine Steuerungselektronik mit einem Auslöser aufweisen, die zur Erfüllung ihrer Funktion auf eine Hilfs- oder Netzspannung angewiesen ist, benötigen netzspannungsunabhängige Fehlerstromschutzschalter zur Realisierung der Auslösefunktion keine Hilfs- oder Netzspannung, sondern weisen zur Realisierung der netzspannungsunabhängigen Auslösung in der Regel einen etwas größeren Summenstromwandler auf, wodurch ein größerer Induktionsstrom in der Sekundärwicklung erzeugt werden kann.

Lichtbogen- bzw. Brandschutzschalter werden zur Erfassung von Störlichtbögen, wie sie an einer defekten Stelle einer elektrischen Leitung - beispielsweise einer lockeren Kabelklemme oder aufgrund eines Kabelbruchs - auftreten können, verwendet. Tritt der Störlichtbogen elektrisch in Reihe zu einem elektrischen Verbraucher auf, so wird der normale Betriebsstrom im Regelfall nicht überschritten, da er durch den Verbraucher begrenzt wird. Aus diesem Grund wird der Störlichtbogen von einer herkömmlichen Überstromschutzeinrichtung, beispielsweise einer Schmelzsicherung oder eines Leitungsschutzschalters, nicht erfasst. Zur Ermittlung, ob ein Störlichtbogen vorliegt, werden durch den Brandschutzschalter sowohl der Spannungsverlauf als auch der Stromverlauf über die Zeit gemessen und hinsichtlich der für einen Störlichtbogen charakteristischen Verläufe analysiert und ausgewertet. In der (englischsprachigen) Fachliteratur werden derartige Schutzeinrichtungen zur Erfassung von Störlichtbögen als "Arc Fault Detection Device" (abgekürzt: AFDD) bezeichnet. Im nordamerikanischen Raum ist die Bezeichnung "Arc Fault Circuit Interrupter" (abgekürzt: AFCI) geläufig.

Daneben existieren auch Gerätebauformen, bei denen die Funktionalität eines Fehlerstrom-Schutzschalters mit der Funktionalität eines Leitungsschutzschalters kombiniert wird: derartige kombinierte Schutzschaltgeräte werden im Deutschen als FI/LS oder im englischsprachigen Raum als RCBO (für Residual current operated Circuit-Breaker with Overcurrent protection) bezeichnet. Diese Kombigeräte haben im Vergleich zu getrennten Fehlerstrom- und Leitungsschutzschaltern den Vorteil, dass jeder Stromkreis seinen eigenen Fehlerstrom-Schutzschalter aufweist: Normalerweise wird ein einziger FehlerstromSchutzschalter für mehrere Stromkreise verwendet. Kommt es zu einem Fehlerstrom, werden somit in Folge alle abgesicherten Stromkreise abgeschaltet. Durch den Einsatz von RCBOs wird nur der jeweils betroffene Stromkreis abgeschaltet.

Tendenziell werden immer mehr Funktionalitäten in die Geräte integriert, d.h. es werden kombinierte Schutzschaltgeräte entwickelt, welche den Funktionsumfang mehrerer Einzelgeräte abdecken: neben den vorstehend bereits beschriebenen FI/LS-Schutz-schalt-geräten, welche den Funktionsumfang eines herkömmlichen Fehlerstromschutzschalters (FI) mit dem eines Leitungsschutzschalters (LS) kombinieren, existieren weitere Bauformen, bei denen beispielsweise die Funktionalität eines Brandschutzschalters in bestehende Geräte wie MCB, RCD oder RCBO/FILS integriert werden.

Insbesondere bei mehrpoligen Fehlerstromschutzschaltern - ob als reiner Fehlerstromschutzschalter oder als kombinierte Gerätebauform wie FI/LS bzw. RCBO - sowie bei kombinierten Schutzschaltgeräten werden elektronische Funktionsbaugruppen verwendet, welche zur Realisierung einer oder mehrerer Funktionen des jeweiligen Schutzschaltgerätes benötigt werden. Derartige elektronische Funktionsbaugruppen müssen einerseits in dem dicht gepackten Gehäuse des jeweiligen Schutzschaltgerätes angeordnet, d.h. aufgenommen und gehaltert, sein, als auch mit elektrischer Energie versorgt werden.

Es ist deshalb die Aufgabe der vorliegenden Erfindung ein aus mehreren Gehäusemodulen gebildetes, modulares Isolierstoffgehäuse für ein mehrpoliges modulares Reiheneinbaugerät sowie ein mehrpoliges modulares Reiheneinbaugerät mit einem derartigen modularen Isolierstoffgehäuse bereitzustellen, welche sich durch eine besonders kompakte Gestaltung und damit durch eine verbesserte Nutzung des zur Verfügung stehenden Bauraumes auszeichnen.

Diese Aufgabe wird erfindungsgemäß durch das modulare Isolierstoffgehäuse sowie das mehrpolige modulare Reiheneinbaugerät gemäß den unabhängigen Ansprüchen gelöst. Vorteilhafte Ausgestaltungen sind Gegenstand der abhängigen Ansprüche.

Das erfindungsgemäße modulare Isolierstoffgehäuse für ein mehrpoliges modulares Reiheneinbaugerät weist eine Frontseite, eine der Frontseite gegenüberliegende Befestigungsseite sowie die Front- und die Befestigungsseite verbindende erste und zweite Schmal- und Breitseiten auf. Weiterhin weist das modulare Isolierstoffgehäuse ein erstes Gehäusemodul sowie ein zweites Gehäusemodul auf, welche dazu vorgesehen und ausgebildet sind, Komponenten des Reiheneinbaugerätes aufzunehmen und zu haltern. Ferner weist das modulare Isolierstoffgehäuse eine Schiebervorrichtung zur Befestigung des Isolierstoffgehäuses an einer Tragschiene auf. Die Schiebervorrichtung weist ihrerseits ein von der Frontseite aus betätigbares Betätigungselement, sowie ein damit über einen Verbindungsbereich verbundenes, an der Befestigungsseite geführtes, von einer Gelöst-Position in eine Verriegelungsposition bewegbares Verriegelungselement auf und ist im Bereich der ersten Schmalseite sowie der Befestigungsseite zwischen dem ersten Gehäusemodul und dem zweiten Gehäusemodul angeordnet.

Eine mittels Werkzeug betätigbare Schiebervorrichtung ist zum Lösen bzw. zum Hintergreifen der Trag- oder Hutschiene durch ein Verriegelungselement lediglich an der Befestigungsseite eines Reiheneinbaugerätes verschiebbar befestigt, wobei zum Bewegen des Verriegelungselements ein Schraubendreher oder dergleichen benötigt wird. Zur komfortableren Befestigung des Reiheneinbaugerätes an der Trag- oder Hutschiene existieren werkzeuglos betätigbare Schiebervorrichtungen, bei denen das Verriegelungselement über einen Verbindungsbereich mit einem im Bereich der Frontseite angeordneten Betätigungselement mechanisch verbunden ist, so dass das an der Befestigungsseite geführte Verriegelungselement von der Frontseite aus manuell, d.h. ohne zusätzliches Werkzeug, betätigbar ist, um das Verriegelungselement in der Verriegelungsposition an der Trag- oder Hutschiene zu verrasten oder in der Gelöst-Position davon zu lösen. Auf diese Weise können auch bei schlecht zugänglichen Verteilerkastenaufbauten einzelne Reiheneinbaugeräte jederzeit aus dem Tragschienen-Verbund gelöst und ersetzt werden.

Das erfindungsgemäße modulare Isolierstoffgehäuse hat demgegenüber den Vorteil, dass die von der Frontseite aus werkzeuglos betätigbare Schiebervorrichtung nicht innerhalb eines oder mehrerer der Gehäusemodule, wo der hierfür benötigte Bauraum knapp bemessen ist, sondern zwischen zwei Gehäusemodulen, wo bei mehrpoligen Reiheneinbaugeräten zwischen den im Bereich der Schmalseite angeordneten Anschlussklemmen ungenutzter Bauraum vorhanden ist, angeordnet, d.h. aufgenommen und gehaltert ist. Der dadurch freiwerdende Bauraum im Inneren der Gehäusemodule kann somit funktional anderweitig genutzt werden.

Mit dem Begriff "modulares Isolierstoffgehäuse" wird vorliegend ein Isolierstoffgehäuse bezeichnet, welches aus mehreren einzelnen Gehäusemodulen, welche im Rahmen der Montage des Reiheneinbaugerätes fest miteinander verbunden werden, zusammengesetzt ist. Die Verbindung der einzelnen Gehäusemodule kann beispielsweise mit Hilfe von Nieten oder Klammern erfolgen. Ein "Gehäusemodul" stellt eine bauliche Einheit dar, in der zumindest ein mittels eines Schaltkontakts unterbrechbarer Strompfad angeordnet und vor Zugriff von außen geschützt ist. Ferner können - je nach Art des Gehäusemoduls - weitere gehäusemodul-spezifische Baugruppen und Komponenten in dem Gehäusemodul angeordnet und vor Zugriff von außen geschützt sein. Eine einzelne Gehäusetrennwand oder ein einzelner Gehäusedeckel stellen in diesem Sinne kein Gehäusemodul dar, da darin keinen Komponenten angeordnet und vor Zugriff von außen geschützt sind.

Ein zweipoliges Reiheneinbaugerät, d.h. ein Reiheneinbaugerät, an das zwei Außenleiter - beispielsweise ein Phasenleiter und ein Neutralleiter für einen Leitungsschutzschalter vom Typ 1+N - angeschlossen werden können, weist somit ein modulares, aus zwei Gehäusemodulen gebildetes Isolierstoffgehäuse auf, wobei das erste Gehäusemodul zum Anschließen und Unterbrechen des Neutralleiters, das zweite Gehäusemodul zum Anschließen und Unterbrechen des Phasenleiters dient. Die beiden Gehäusemodule müssen dabei nicht identisch aufgebaut sein: es ist daher möglich, beim zweiten Gehäusemodul zur Unterbrechung des Neutralleiters nicht benötigte Komponenten wegzulassen, beispielsweise die magnetische und/oder thermische Auslösevorrichtung zum Öffnen des Schaltkontakts im Falle eines Kurzschlusses oder einer elektrischen Überlast. Für ein vierpoliges Reiheneinbaugerät zum Unterbrechen dreier Phasenleiter sowie des Neutralleiters ist das modulare Isolierstoffgehäuse entsprechend aus vier Gehäusemodulen gebildet.

In einer vorteilhaften Weiterbildung des modularen Isolierstoffgehäuses ist der Verbindungsbereich im Bereich der ersten Schmalseite formschlüssig innenliegend geführt.

Hierunter ist zu verstehen, dass lediglich das Betätigungselement, nicht aber der der Verbindungsbereich an der äußeren Oberfläche der ersten Schmalseite des modularen Isolierstoffgehäuses angeordnet ist, wodurch eine Verschmutzung oder Beschädigung des Verbindungsbereichs sicher vermieden werden kann. Eine Führung der Schiebevorrichtung ist dabei - angepasst an die Form der Schiebevorrichtung - am ersten und/oder zweiten Gehäusemodul ausgebildet sowie zumindest teilweise innerhalb des Gehäuses angeordnet.

In einer weiteren vorteilhaften Weiterbildung des modularen Isolierstoffgehäuses ist die Schiebervorrichtung einstückig und zumindest der Verbindungsbereich elastisch zurückstellend ausgeführt.

In der Verriegelungsstellung der Schiebervorrichtung weist diese eine Form auf, die der Form entspricht, die sie auch als loses Teil einnehmen würde. Die elastisch zurückstellende Kraftwirkung in die ursprüngliche Form ergibt sich aus einer Wechselwirkung der Schiebervorrichtung mit deren Führung, welche am ersten und/oder zweiten Gehäusemodul ausgebildet ist. Aufgrund des beliebig geformten Verbindungsbereiches bzw. der entsprechenden Form der Führung der Schiebervorrichtung bewirkt eine durch Betätigung des Betätigungselementes verursachte Verschiebung des Verriegelungselementes eine elastische Verformung des Verbindungsbereichs, aufgrund derer das Verriegelungselement in die Verriegelungsstellung zurückgedrängt wird. Mit anderen Worten, eine elastische Deformation des Verbindungsbereiches führt stets zu einer Entwicklung einer elastischen Federkraft, welche die Schiebervorrichtung in die Verriegelungsstellung zurückzwingt.

In einer weiteren vorteilhaften Weiterbildung des modularen Isolierstoffgehäuses weist die Schiebervorrichtung wenigstens ein Federelement zur Erzeugung einer Rückstellkraft auf, welche das Verriegelungselement von einer Gelöst-Position in eine Verriegelungsposition drängt.

Mit Hilfe des Federelements wird über das Verriegelungselement eine zusätzliche Kraft auf die Kontaktstelle mit der Trag- oder Hutschiene ausgeübt, um das Reiheneinbaugerät sicher daran zu befestigen. Das Federelement ist dabei vorzugsweise einstückig an das Verriegelungselement angeformt und bildet eine federähnliche Struktur aus.

In einer weiteren vorteilhaften Weiterbildung des modularen Isolierstoffgehäuses ist die Schiebervorrichtung aus einem nicht-metallischem Material, insbesondere aus Kunststoff, gebildet. Kunststoff ist ein Material, das sich insbesondere durch Bruchfestigkeit sowie Temperatur- und Wärmeformbeständigkeit auszeichnet und zudem eine chemische Beständigkeit aufweist, die Alterungsprozesse nahezu ausschließt.

In einer weiteren vorteilhaften Weiterbildung weist das modulare Isolierstoffgehäuse im Bereich der ersten Schmalseite zwischen dem ersten Gehäusemodul und dem zweiten Gehäusemodul angeordnete Ausblasöffnungen zum Ausleiten von Schaltgasen auf, wobei der Verbindungsbereich der Schiebervorrichtung im Bereich der Ausblasöffnungen seinerseits Öffnungen zum Durchleiten der Schaltgase aufweist, deren Lage in der Verriegelungsposition der Schiebervorrichtung mit der Lage der Ausblasöffnungen korreliert.

Durch die im Verbindungsbereich ausgebildeten Öffnungen können die bei Auslösen des Reiheneinbaugerätes, d.h. Öffnen eines darin angeordneten Schaltkontakts, auftretenden Schaltgase ungehindert durch die Ausblasöffnungen ins Freie gelangen. Hierdurch werden Druck und Temperatur im Inneren des Isolierstoffgehäuses, und damit die Gefahr schwerer Beschädigungen des Reiheneinbaugeräts wirksam reduziert. Weiterhin können die Öffnungen auch zur Durchlüftung etwaiger verbauter Zusatzkomponenten verwendet werden.

In einer weiteren vorteilhaften Weiterbildung weist das modulare Isolierstoffgehäuse zumindest ein weiteres Gehäusemodul auf, welches dazu vorgesehen und ausgebildet ist, weitere Komponenten des Reiheneinbaugerätes aufzunehmen und zu haltern.

Anstelle eines zweipoligen Reiheneinbaugerätes, welches aus dem ersten Gehäusemodul sowie dem zweiten Gehäusemodul besteht und eine Kontaktierung mit zwei Außenleitern, beispielsweise einem Phasenleiter und einem Neutralleiter, ermöglicht, können durch Hinzufügen, d.h. durch Anordnung weiterer Gehäusemodule auch dreipolige oder vierpolige Reiheneinbaugeräte aufgebaut werden. Ein dreipoliges Reiheneinbaugerät weist somit ein weiteres, drittes Gehäusemodul auf und kann somit mit drei Außenleitern, beispielsweise zwei Phasenleitern sowie dem Neutralleiter, kontaktiert werden. Entsprechend ist ein vierpoliges Reiheneinbaugerät aus vier Gehäusemodulen gebildet und dient der Kontaktierung mit vier Außenleitern, beispielsweise drei Phasenleitern sowie dem Neutralleiter. Dies ermöglicht eine einfache Bildung von Gerätevarianten durch Verwendung einheitlicher Gehäusemodule, ohne dass dabei die Anzahl der verschiedenen das Isolierstoffgehäuse bildenden Bauteile oder Baugruppen deutlich erhöht wird.

In einer weiteren vorteilhaften Weiterbildung weist das modulare Isolierstoffgehäuse zumindest eine weitere Schiebervorrichtung zur Befestigung des Isolierstoffgehäuses an der Tragschiene auf.

Ist eine höhere Haltekraft erforderlich, so können weitere Schiebervorrichtung zur Befestigung des Isolierstoffgehäuses an der Trag- oder Hutschiene verwendet werden. Ein dreipoliges Reiheneinbaugerät kann an der ersten Schmalseite somit bis zu zwei, ein vierpoliges Reiheneinbaugerät bis zu drei Schiebervorrichtungen zur Befestigung des Reiheneinbaugerätes an der Trag- oder Hutschiene aufweisen. Ferner ist es möglich, auch an der gegenüberliegenden zweiten Schmalseite eine oder mehrere Schiebervorrichtungen zu montieren.

Das erfindungsgemäße mehrpolige modulare Reiheneinbaugerät weist ein modulares Isolierstoffgehäuse der vorstehend beschriebenen Art auf. Hinsichtlich der prinzipiellen Vorteile des erfindungsgemäßen mehrpoligen modularen Reiheneinbaugerätes wird auf die vorstehend erläuterten Vorteile das erfindungsgemäße modulare Isolierstoffgehäuse betreffend verwiesen.

In einer weiteren vorteilhaften Weiterbildung ist das mehrpolige modulare Reiheneinbaugerät als zweipoliger, dreipoliger oder vierpoliger Leitungsschutzschalter oder Fehlerstromschutzschalter mit einer entsprechenden Anzahl an Gehäusemodulen ausgebildet.

Zur Bildung eines zweipoligen, dreipoligen oder vierpoligen Reiheneinbaugerätes - beispielsweise Leitungsschutzschalter, Fehlerstromschutzschalter oder Kombigerät - wird eine der Polzahl entsprechende Anzahl an Gehäusemodulen benötigt. Unter der Anzahl der Pole wird dabei die Anzahl der an das Reiheneinbaugerät anschließbaren und mit Hilfe des Reiheneinbaugerätes unterbrechbaren Außenleiter - Phasenleiter und Neutralleiter - verstanden. Durch die modulare Gestaltung des Isolierstoffgehäuses können dabei verschiedene Varianten an Reiheneinbaugeräten gebildet werden, ohne dass hierzu eine entsprechende Anzahl verschiedener Gehäusetypen erforderlich wäre. Die Modularität ermöglicht somit eine höhere Variantenvielfalt bei gleichzeitig niedriger Anzahl an Gehäusebauteilen, wodurch die Werkzeug-, Lagerhaltungs- und Herstellkosten deutlich reduziert werden können.

Im Folgenden wird ein Ausführungsbeispiel des modularen Isolierstoffgehäuses unter Bezug auf die beigefügten Figuren näher erläutert. In den Figuren sind:
- Figur 1: eine schematische Darstellung eines aus zwei Gehäusemodulen gebildeten modularen Isolierstoffgehäuses mit einer dazwischen angeordneten Schiebervorrichtung;
- Figur 2: eine schematische Einzeldarstellung der Schiebervorrichtung;
- Figur 3: eine schematische Darstellung eines einzelnen Gehäusemoduls mit einer daran montierten Schiebervorrichtung.

In den verschiedenen Figuren der Zeichnung sind gleiche Teile stets mit dem gleichen Bezugszeichen versehen. Die Beschreibung gilt für alle Zeichnungsfiguren, in denen das entsprechende Teil ebenfalls zu erkennen ist.

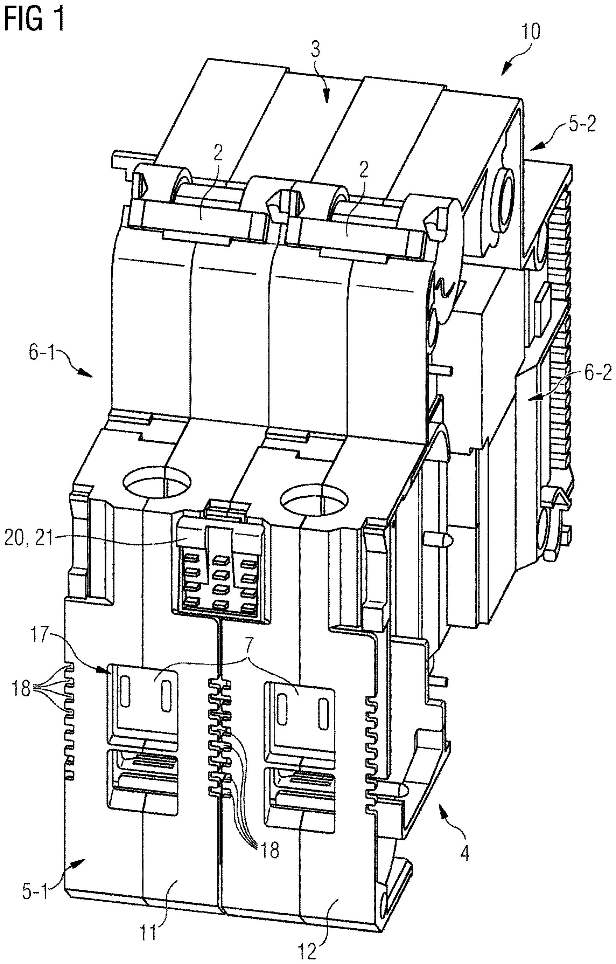

Figur 1 zeigt schematisch ein aus zwei Gehäusemodulen, einem ersten Gehäusemodul 11 und einem zweiten Gehäusemodul 12 gebildetes, modulares Isolierstoffgehäuse 10 mit einer dazwischen angeordneten Schiebervorrichtung 20 in perspektivischer Ansicht, wobei äußeren Gehäuseabdeckungen zum besseren Verständnis weggelassen wurden. Das modulare Isolierstoffgehäuse 10 weist eine Frontseite 3, eine der Frontseite 3 gegenüberliegende Befestigungsseite 4 auf. Die Frontseite 3 und die Befestigungsseite 4 sind durch eine erste Schmalseite 5-1, eine zweite Schmalseite 5-2, eine erste Breitseite 6-1 sowie zweite Breitseite 6-2 miteinander verbunden. An der Frontseite 3 weisen das erste Gehäusemodul 11 und das zweite Gehäusemodul 12 jeweils ein Betätigungselement 2 zur manuellen Betätigung des Reiheneinbaugerätes, d.h. zum Ein- und Ausschalten per Hand, auf.

Weiterhin weisen das das erste Gehäusemodul 11 und das zweite Gehäusemodul 12 hinter der ersten Schmalseite 5-1 jeweils einen Anschlussraum zur Anordnung eines elektrischen Anschlusselements, beispielsweise eine Anschlussklemme 7, auf, welcher einen überwiegenden Teil der verfügbaren Innenbreite des jeweiligen Gehäusemoduls einnimmt. Die Anschlussklemme 7 dient der elektrischen Kontaktierung eines Außenleiters, beispielsweise eines Phasenleiters oder eines Neutralleiters, und ist durch eine in der ersten Schmalseite 5-1 ausgebildete Kontaktierungsöffnung 17 von außen zugänglich. Die Anschlussklemme 7 ist jedoch nicht Teil des Isolierstoffgehäuses 10, sondern stellt eine Baugruppe/Komponente des jeweiligen Reiheneinbaugerätes dar.

Bei einer Auslösung des Reiheneinbaugerätes - beispielsweise im Falle eines Kurzschlusses, einer Überlast oder eines Fehlerstromzustandes - wird durch Öffnen der jedem Außenleiter zugeordneten Schaltkontakte der Stromfluss unterbrochen. Da beim Öffnen eines bestromten Schaltkontakts ein Lichtbogen entsteht, wird die den Lichtbogen umgebende Luft stark erwärmt und ionisiert - es bilden sich sogenannte Schaltgase. Diese Phase geht mit hoher Temperatur und hohem Druck einher, weswegen die Schaltgase möglichst schnell aus dem Isolierstoffgehäuse 10 herausgeführt werden müssen, um Beschädigungen an Komponenten des Reiheneinbaugerätes zu verhindern. Hierzu weisen das erste und zweite Gehäusemodul 11, 12 des Isolierstoffgehäuses 10 sogenannte Ausblasöffnungen 18 auf, welche jeweils an der ersten Schmalseite 5-1 zu beiden Seiten der jeweiligen Kontaktierungsöffnung 17 angeordnet sind, um bei einer Auslösung des Reiheneinbaugerätes die Schaltgase aus dem Isolierstoffgehäuse herauszuleiten.

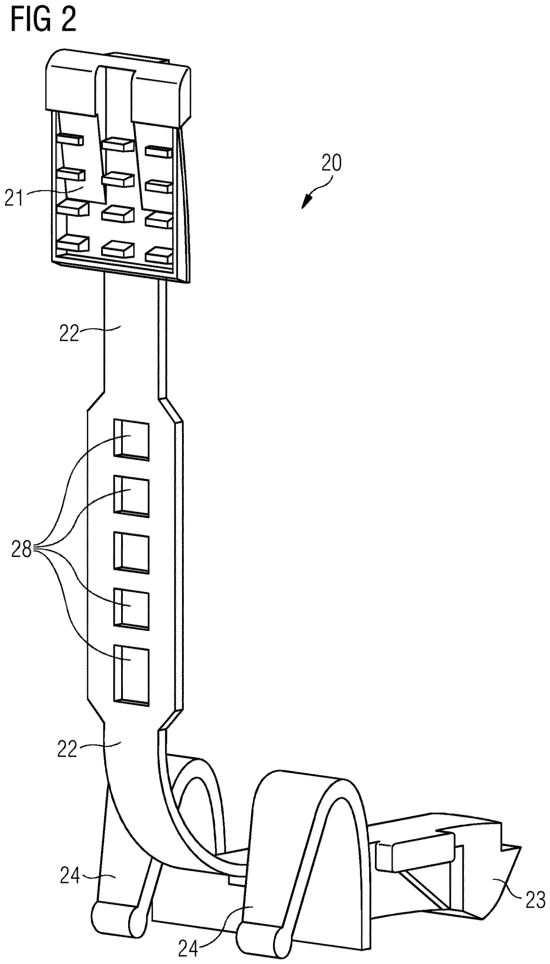

Ferner ist zwischen dem ersten Gehäusemodul 11 und dem zweiten Gehäusemodul 12 eine Schiebervorrichtung 20 (siehe Fig.2) montiert, von der in der Darstellung der Figur 1 lediglich deren Betätigungselement 21 zur manuellen Betätigung der Schiebervorrichtung 20 sichtbar ist.

Figur 2 zeigt eine schematische Einzeldarstellung der Schiebervorrichtung 20 in perspektivischer Ansicht. Die Schiebervorrichtung 20 dient dazu, das Reiheneinbaugerät an der Befestigungsseite 4 des Isolierstoffgehäuses 10 mit einer in einem Elektroinstallationsverteiler oder dergleichen angeordneten Trag- oder Hutschiene zu befestigen. Hierzu ist das Betätigungselement 21 über einen Verbindungsbereich 22 mit einem Verriegelungselement 23 der Schiebervorrichtung 20 mechanisch verbunden, so dass durch manuelles Ziehen am Betätigungselements 21 in Richtung der Frontseite 3 das Verriegelungselement 23 von einer Verriegelungsposition in eine Gelöst-Position verbracht wird. Dabei wird das Verriegelungselement 23 hinter der Trag- bzw. Hutschiene zurückgezogen, wodurch die Verriegelung des Reiheneinbaugerätes gelöst wird.

Weiterhin weist die Schiebervorrichtung 20 zwei Federelemente 24 auf, welche in einem Übergangsbereich zwischen Verbindungsbereich 22 und Verriegelungselement 23 an die Schiebervorrichtung 20 angeformt sind. Die beiden Federelemente 24 sind als Blattfedern ausgebildet und gegen das Isolierstoffgehäuse 10 abgestützt. Sie dienen dazu, eine zusätzliche Kraft auf das Verriegelungselement 23 auszuüben, welche dieses in seine Verriegelungsposition drückt. Im montierten Zustand der Schiebervorrichtung 20 im Isolierstoffgehäuse 10 stellt diese Verriegelungsposition den Normal- oder Ruhezustand der Schiebervorrichtung 20 dar.

Aus Sicherheitsgründen ist der Verbindungsbereich 22 innerhalb des Isolierstoffgehäuses 10 zwischen dem ersten Gehäusemodul 11 und dem zweiten Gehäusemodul 12 angeordnet und geführt - lediglich das Betätigungselement 21 im oberen Bereich der ersten Schmalseite 5-1 sowie das an der Befestigungsseite 4 angeordnete Verriegelungselement 23 zum Hintergreifen der Trag- bzw. Hutschiene sind an der Oberfläche des Isolierstoffgehäuses 10 sichtbar. Der Verbindungsbereich 22 der Schiebervorrichtung 20 weist ferner mehrere Öffnungen 28 auf, welche im Ruhezustand, d.h. in der Verriegelungsposition hinsichtlich ihrer Lage mit den Ausblasöffnungen 18 des Isolierstoffgehäuses 10 korrelieren, d.h. in der Verriegelungsposition der Schiebervorrichtung 20, bei der das Reiheneinbaugerät fest aber lösbar an der Trag- oder Hutschiene befestigt ist, können die beim Auftreten eines Lichtbogens entstehenden Schaltgase durch die im Verbindungsbereich 22 der Schiebervorrichtung 20 angeordneten Öffnungen 28 und die Ausblasöffnungen 18 aus dem Isolierstoffgehäuse 10 ins Freie entweichen.

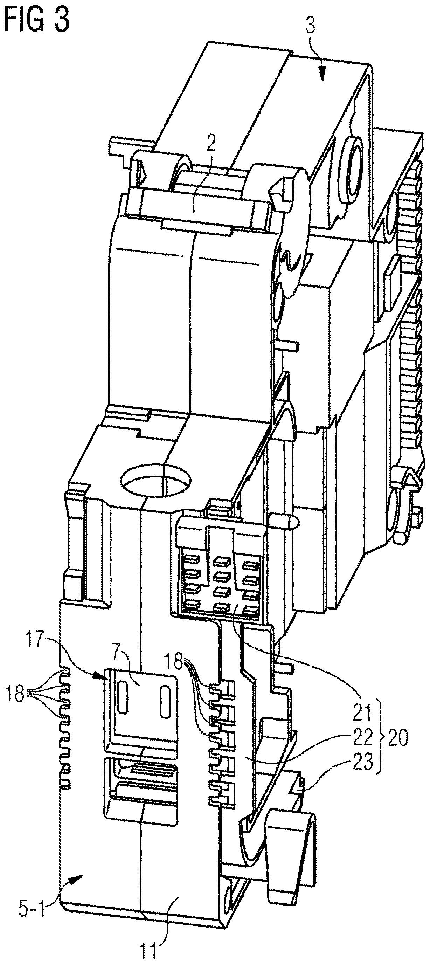

Um dieses Zusammenspiel zuverdeutlichen zeigt Figur 3 eine schematische Darstellung des einzelnen Gehäusemoduls 11 mit der daran vormontierten Schiebervorrichtung 20 in ihrer Ruheposition. Die Schiebervorrichtung 20 wird dabei einfach in eine am Gehäusemodul 11 ausgebildete Lager- und Führungskontur eingelegt, was die Montage deutlich vereinfacht. Die im Verbindungsbereich 22 ausgebildeten Öffnungen 28 liegen dabei in der Ruheposition unmittelbar hinter den Ausblasöffnungen 18, so dass Schaltgase ungehindert entweichen können. Dies bedeutet jedoch nicht, dass alle Ausblasöffnungen 18 frei sind: einige einzelne können durch den Verbindungsbereich 22 verdeckt sein, wobei die verbleibende Anzahl an freien Ausblasöffnungen 18 ausreicht, um die Schaltgase ohne Beschädigung des Reiheneinbaugerätes ins Freie zu leiten.

Weiterhin ist anhand der Darstellung der Figur 3 gut zu erkennen, wie die Schiebervorrichtung 20 platzsparend zwischen den beiden Gehäusemodulen 11 und 12 angeordnet ist, und wie der Verbindungsbereich 22 zwischen hinter der äußeren Oberfläche der ersten Schmalseite 5-1 des Isolierstoffgehäuses 10 in einem Bereich zwischen den Anschlussklemmen 7 geführt ist.

### Bezugszeichenliste:

- 2: Betätigungselement
- 3: Frontseite
- 4: Befestigungsseite
- 5-1: erste Schmalseite
- 5-2: zweite Schmalseite
- 6-1: erste Breitseite
- 6-2: zweite Breitseite
- 7: Anschlussklemme
- 10: Isolierstoffgehäuse
- 11: erstes Gehäusemodul
- 12: zweites Gehäusemodul
- 17: Kontaktierungsöffnung
- 18: Ausblasöffnung
- 20: Schiebervorrichtung
- 21: Betätigungselement
- 22: Verbindungsbereich
- 23: Verriegelungselement
- 24: Federelement
- 28: Öffnung

## Patentansprüche

1. Modulares Isolierstoffgehäuse (10) für ein mehrpoliges modulares Reiheneinbaugerät, aufweisend eine Frontseite (3), eine der Frontseite (3) gegenüberliegende Befestigungsseite (4) sowie die Front- und die Befestigungsseite (3, 4) verbindende erste und zweite Schmal- und Breitseiten (5-1, 5-2, 6-1, 6-2),
- mit einem ersten Gehäusemodul (11) und einem zweiten Gehäusemodul (12), welche dazu vorgesehen und ausgebildet sind, Komponenten des Reiheneinbaugerätes aufzunehmen und zu haltern,
- mit einer Schiebervorrichtung (20) zur Befestigung des Isolierstoffgehäuses (10) an einer Tragschiene, aufweisend ein von der Frontseite (3) aus betätigbares Betätigungselement (21), sowie ein damit über einen Verbindungsbereich (22) verbundenes, an der Befestigungsseite geführtes, von einer Gelöst-Position in eine Verriegelungsposition bewegbares Verriegelungselement (23),
**dadurch gekennzeichnet,**
**dass** die Schiebervorrichtung (20) im Bereich der ersten Schmalseite (5-1) und der Befestigungsseite (4) zwischen dem ersten Gehäusemodul (11) und einem zweiten Gehäusemodul (12) angeordnet ist.

2. Modulares Isolierstoffgehäuse (10) nach Anspruch 1,
**dadurch gekennzeichnet,**
**dass** der Verbindungsbereich (22) im Bereich der ersten Schmalseite (5-1) formschlüssig innenliegend geführt ist.

3. Modulares Isolierstoffgehäuse (10) nach einem der vorherigen Ansprüche,
**dadurch gekennzeichnet,**
**dass** die Schiebervorrichtung (20) einstückig und zumindest der Verbindungsbereich (22) elastisch zurückstellend ausgeführt ist.

4. Modulares Isolierstoffgehäuse (10) nach einem der vorherigen Ansprüche,
**dadurch gekennzeichnet,**
**dass** die Schiebervorrichtung (20) wenigstens ein Federelement (24) zur Erzeugung einer Rückstellkraft aufweist, welche das Verriegelungselement (23) von einer Gelöst-Position in eine Verriegelungsposition drängt.

5. Modulares Isolierstoffgehäuse (10) nach einem der vorherigen Ansprüche,
**dadurch gekennzeichnet,**
**dass** die Schiebervorrichtung (20) aus einem nicht-metallischem Material, insbesondere aus Kunststoff, gebildet ist.

6. Modulares Isolierstoffgehäuse (10) nach einem der vorherigen Ansprüche,
**dadurch gekennzeichnet,**
- **dass** das Isolierstoffgehäuse (10) im Bereich der ersten Schmalseite (5-1) zwischen dem ersten Gehäusemodul (11) und dem zweiten Gehäusemodul (12) angeordnete Ausblasöffnungen (18) zum Ausleiten von Schaltgasen aufweist und
- **dass** der Verbindungsbereich (22) im Bereich der Ausblasöffnungen (18) seinerseits Öffnungen (28) zum Durchleiten der Schaltgase aufweist, deren Lage in der Verriegelungsposition der Schiebervorrichtung (20) mit der Lage der Ausblasöffnungen (18) korreliert.

7. Modulares Isolierstoffgehäuse (10) nach einem der vorherigen Ansprüche,
**dadurch gekennzeichnet,**
**dass** das modulare Isolierstoffgehäuse (10) zumindest ein weiteres Gehäusemodul aufweist, welches dazu vorgesehen und ausgebildet ist, weitere Komponenten des Reiheneinbaugerätes aufzunehmen und zu haltern.

8. Modulares Isolierstoffgehäuse (10) nach Anspruch 7,
**dadurch gekennzeichnet,**
**dass** das modulare Isolierstoffgehäuse (10) zumindest eine weitere Schiebervorrichtung (20) zur Befestigung des Isolierstoffgehäuses (10) an der Tragschiene aufweist.

9. Mehrpoliges modulares Reiheneinbaugerät, aufweisend ein modulares Isolierstoffgehäuse (10) nach einem der Ansprüche 1 bis 8.

10. Mehrpoliges modulares Reiheneinbaugerät nach Anspruch 9,
**dadurch gekennzeichnet,**
**dass** das mehrpolige modulare Reiheneinbaugerät als 2-, 3- oder 4-poliger Leitungsschutzschalter oder Fehlerstromschutzschalter mit einer entsprechenden Anzahl an Gehäusemodulen (11, 12) ausgebildet ist.

## Claims

1. Modular insulating-material housing (10) for a multi-pole modular rail-mounted device, having a front side (3), a fastening side (4) on the opposite side from the front side (3), and first and second narrow and broad sides (5-1, 5-2, 6-1, 6-2) connecting the front side (3) and the fastening side (4),
- having a first housing module (11) and a second housing module (12) which are provided and designed to receive and to hold components of the rail-mounted device,
- having a slider device (20) for fastening the insulating-material housing (10) to a mounting rail, having an actuating element (21) which is actuable from the front side (3), and a locking element (23) which is connected thereto via a connecting region (22), is guided on the fastening side and is movable from a released position into a locking position,
**characterized**
**in that** the slider device (20) is arranged in the region of the first narrow side (5-1) and the fastening side (4) between the first housing module (11) and a second housing module (12).

2. Modular insulating-material housing (10) according to Claim 1,
**characterized**
**in that** the connecting region (22) is guided in a form-fitting manner internally in the region of the first narrow side (5-1).

3. Modular insulating-material housing (10) according to either of the preceding claims,
**characterized**
**in that** the slider device (20) is designed in one piece and at least the connecting region (22) is designed for resetting elastically.

4. Modular insulating-material housing (10) according to one of the preceding claims,
**characterized**
**in that** the slider device (20) has at least one spring element (24) for generating a resetting force which forces the locking element (23) from a released position into a locking position.

5. Modular insulating-material housing (10) according to one of the preceding claims,
**characterized**
**in that** the slider device (20) is formed from a non-metallic material, in particular from plastic.

6. Modular insulating-material housing (10) according to one of the preceding claims,
**characterized**
- **in that** the insulating-material housing (10) has exhaust openings (18) arranged in the region of the first narrow side (5-1) between the first housing module (11) and the second housing module (12) for discharging switching gases, and
- **in that** the connecting region (22), for its part, has openings (28) in the region of the exhaust openings (18) for the passage of the switching gases, the position of which openings correlates with the position of the exhaust openings (18) in the locking position of the slider device (20) .

7. Modular insulating-material housing (10) according to one of the preceding claims,
**characterized**
**in that** the modular insulating-material housing (10) has at least one further housing module which is provided and designed to receive and to hold further components of the rail-mounted device.

8. Modular insulating-material housing (10) according to Claim 7,
**characterized**
**in that** the modular insulating-material housing (10) has at least one further slider device (20) for fastening the insulating-material housing (10) to the mounting rail.

9. Multi-pole modular rail-mounted device, having a modular insulating-material housing (10) according to one of Claims 1 to 8.

10. Multi-pole modular rail-mounted device according to Claim 9,
**characterized**
**in that** the multi-pole modular rail-mounted device is designed as a 2-, 3- or 4-pole line circuit breaker or fault current circuit breaker having a corresponding number of housing modules (11, 12).

## Revendications

1. Boîtier modulaire en matière isolante (10) pour un appareil modulaire multipolaire à montage en série, comprenant une face avant (3), une face de fixation (4) opposée à la face avant (3) ainsi que des premières et deuxièmes faces étroites et larges (5-1, 5-2, 6-1, 6-2) reliant la face avant et la face de fixation (3, 4),
- avec un premier module de boîtier (11) et un deuxième module de boîtier (12), lesquels sont prévus et conçus pour recevoir et maintenir des composants de l'appareil à montage en série,
- avec un dispositif coulissant (20) pour la fixation du boîtier en matière isolante (10) sur un rail porteur, comprenant un élément d'actionnement (21) actionnable par la face avant (3), ainsi qu'un élément de verrouillage (23), mobile d'une position desserrée vers une position de verrouillage, guidé sur la face de fixation, relié par l'intermédiaire d'une zone de liaison (22) audit élément d'actionnement (21),
**caractérisé**
**en ce que** le dispositif coulissant (20) est disposé dans la zone de la première face étroite (5-1) et de la face de fixation (4) entre le premier module de boîtier (11) et un deuxième module de boîtier (12).

2. Boîtier modulaire en matière isolante (10) selon la revendication 1,
**caractérisé**
**en ce que** la zone de liaison (22) est guidée à l'intérieur par complémentarité de forme dans la zone de la première face étroite (5-1).

3. Boîtier modulaire en matière isolante (10) selon l'une des revendications précédentes,
**caractérisé**
**en ce que** le dispositif coulissant (20) se présente d'une seule pièce et au moins la zone de liaison (22) se présente de manière élastiquement repositionnable.

4. Boîtier modulaire en matière isolante (10) selon l'une des revendications précédentes,
**caractérisé**
**en ce que** le dispositif coulissant (20) comprend au moins un élément ressort (24) pour la création d'une force de rappel, laquelle pousse l'élément de verrouillage (23) d'une position desserrée vers une position de verrouillage.

5. Boîtier modulaire en matière isolante (10) selon l'une des revendications précédentes,
**caractérisé**
**en ce que** le dispositif coulissant (20) est formé à partir d'un matériau non métallique, en particulier à partir de matière plastique.

6. Boîtier modulaire en matière isolante (10) selon l'une des revendications précédentes,
**caractérisé**
- **en ce que** le boîtier en matière isolante (10) comprend des ouvertures de soufflage (18), disposées dans la zone de la première face étroite (5-1) entre le premier module de boîtier (11) et le deuxième module de boîtier (12), pour l'évacuation de gaz de coupure et
- **en ce que** la zone de liaison (22) comprend des ouvertures (28) à leur tour dans la zone des ouvertures de soufflage (18) pour le passage des gaz de coupure, dont l'emplacement dans la position de verrouillage du dispositif coulissant (20) est corrélé à l'emplacement des ouvertures de soufflage (18).

7. Boîtier modulaire en matière isolante (10) selon l'une des revendications précédentes,
**caractérisé**
- **en ce que** le boîtier modulaire en matière isolante (10) comprend au moins un module de boîtier supplémentaire, lequel est prévu et conçu pour recevoir et maintenir des composants supplémentaires de l'appareil à montage en série.

8. Boîtier modulaire en matière isolante (10) selon la revendication 7,
**caractérisé**
**en ce que** le boîtier modulaire en matière isolante (10) comprend au moins un dispositif coulissant (20) supplémentaire pour la fixation du boîtier en matière isolante (10) sur le rail porteur.

9. Appareil modulaire multipolaire à montage en série, comprenant un boîtier modulaire en matière isolante (10) selon l'une des revendications 1 à 8.

10. Appareil modulaire multipolaire à montage en série selon la revendication 9,
**caractérisé**
**en ce que** l'appareil modulaire multipolaire à montage en série est conçu sous forme de disjoncteur de protection à courant de défaut ou de disjoncteur de protection de ligne à 2, 3 ou 4 pôles avec une pluralité correspondante de modules de boîtier (11, 12).
